# EUROPÄISCHE PATENTSCHRIFT

(11) **EP 3 916 638 B1**
(45) Veröffentlichungstag und Bekanntmachung des Hinweises auf die Patenterteilung: **16.07.2025**
(21) Anmeldenummer: 20177436.1
(22) Anmeldetag: 29.05.2020
(51) Int. Cl.: G06N 3/047, G06N 3/088, G06N 3/086, G06F 30/27, G06N 3/045

(54) **RECHNERGESTÜTZTES KONSTRUKTIONSVERFAHREN UND KONSTRUKTIONSSYSTEM**
COMPUTER BASED DESIGN METHOD AND DESIGN SYSTEM
PROCÉDÉ DE CONSTRUCTION ASSISTÉE PAR ORDINATEUR ET SYSTÈME DE CONSTRUCTION

(43) Veröffentlichungstag der Anmeldung: 01.12.2021
(73) Patentinhaber: Siemens Aktiengesellschaft, 80333 München (DE)
(72) Erfinder: Depeweg, Stefan, 81673 München (DE); Nouri, Behnam, 10627 Berlin (DE); Sterzing, Volkmar, 85579 Neubiberg (DE)
(74) Vertreter: Siemens Patent Attorneys

(56) Entgegenhaltungen:
- US-A1- 2018 260 501
- GONG LI ET AL: "Applications of Bayesian methods in wind energy conversion systems", RENEWABLE ENERGY, PERGAMON PRESS, OXFORD, GB, vol. 43, 23 December 2011 (2011-12-23), pages 1 - 8, XP028397753, ISSN: 0960-1481, [retrieved on 20120104], DOI: 10.1016/J.RENENE.2011.12.006
- VIKRAM MULLACHERY ET AL: "A study of Bayesian Neural Networks Bayesian Neural Networks", 1 January 2018 (2018-01-01), XP055690393, Retrieved from the Internet <URL:https://arxiv.org/ftp/arxiv/papers/1801/1801.07710.pdf> [retrieved on 20200429]
- WEI CHEN ET AL: "PaDGAN: A Generative Adversarial Network for Performance Augmented Diverse Designs", ARXIV.ORG, CORNELL UNIVERSITY LIBRARY, 201 OLIN LIBRARY CORNELL UNIVERSITY ITHACA, NY 14853, 26 February 2020 (2020-02-26), XP081608304
- DE SOUZA BORGES FERREIRA RAQUEL ET AL: "Automated Geometric Shape Deviation Modeling for Additive Manufacturing Systems via Bayesian Neural Networks", IEEE TRANSACTIONS ON AUTOMATION SCIENCE AND ENGINEERING, IEEE SERVICE CENTER, NEW YORK, NY, US, vol. 17, no. 2, 27 September 2019 (2019-09-27), pages 584 - 598, XP011782765, ISSN: 1545-5955, [retrieved on 20200406], DOI: 10.1109/TASE.2019.2936821

## Beschreibung

Zum Entwerfen von komplexen technischen Produkten, wie z. B. Turbinenschaufeln, Windturbinen, Gasturbinen, Robotern, Kraftfahrzeugen oder deren Komponenten werden in zunehmendem Maße rechnergestützte Konstruktions- oder Planungsinstrumente eingesetzt. Derartige Konstruktionssysteme bilden zwar selbst ein spezialisiertes technisches Gebiet, können aber in der Regel zur Konstruktion ganz unterschiedlicher technischer Produkte eingesetzt werden.

Technische Produkte auf unterschiedlichen technischen Gebieten unterliegen in der Regel auch unterschiedlichen technischen Anforderungen, die als Konstruktionskriterien vorzugeben sind. Derartige Konstruktionskriterien können beispielsweise einen Wirkungsgrad, eine Schwingungsneigung, eine Temperaturbelastung, eine Wärmeleitung, eine aerodynamische Effizienz, eine Performanz, einen Ressourcenverbrauch, Emissionen, eine Materialermüdung, eine Befestigung und/oder einen Verschleiß eines jeweiligen Produkts oder eines seiner Komponenten betreffen. Beim Entwurf eines technischen Produkts sind meist eine Vielzahl von gegebenenfalls konkurrierenden Konstruktionskriterien zu berücksichtigen, die in ihrer Gesamtheit vom fertigen Produkt möglichst gut zu erfüllen sind.

Traditionellerweise werden derartige Entwürfe von Experten ausgeführt, die einen Konstruktionsvorschlag erstellen, dessen Qualität bewerten und gegebenenfalls abhängig davon den Entwurf nachbessern. Eine solche Vorgehensweise ist jedoch häufig verhältnismäßig aufwändig. Zudem sind bei einem Wechsel der Konstruktionskriterien, des zu konstruierenden Produkts und/oder des technischen Gebiets viele Konstruktionsschritte erneut durchzuführen.

Aus der Offenlegungsschrift WO 2020/007844 A1 ist bekannt, zum Entwerfen einer Strömungsmaschinenschaufel ein System neuronaler Netze zu verwenden, die verschiedene Schaufelparameter automatisch ermitteln. Hierbei werden jedoch häufig auch weniger brauchbare Konstruktionsvarianten erzeugt. Insbesondere besteht oft eine Unsicherheit über die Brauchbarkeit einer jeweiligen Konstruktionsvariante. DE SOUZA BORGES FERREIRA RAQUEL ET AL: "Automated Geometrie Shape Deviation Modeling for Additive Manufacturing Systems via Bayesian Neural Networks",IEEE TRANSACTIONS ON AUTOMATION SCIENCE AND ENGINEERING, IEEE SERVICE CENTER, NEW YORK, NY, US, Bd. 17, Nr. 2, 27. September 2019 (2019-09-27), Seiten 584-598, ISSN: 1545-5955, DOI: 10.1109/ TASE.2019.2936821, offenbart ein weiteres Konstruktionsverfahren.

Es ist Aufgabe der vorliegenden Erfindung, ein rechnergestütztes Konstruktionsverfahren und Konstruktionssystem zum Generieren von ein technisches Produkt spezifizierenden Strukturdatensätzen anzugeben, mit denen sich technische Produkts effizienter entwerfen lassen.

Gelöst wird diese Aufgabe durch ein Konstruktionsverfahren mit den Merkmalen des Patentanspruchs 1, durch ein Konstruktionssystem mit den Merkmalen des Patentanspruchs 10, durch ein Computerprogrammprodukt mit den Merkmalen des Patentanspruchs 11 sowie durch ein computerlesbares Speichermedium mit den Merkmalen des Patentanspruchs 12.

Zum Generieren von ein technisches Produkt spezifizierenden Strukturdatensätzen werden für eine Vielzahl von Konstruktionsvarianten des technischen Produkts jeweils ein die jeweilige Konstruktionsvariante spezifizierender Trainings-Strukturdatensatz sowie ein ein vorgegebenes Konstruktionskriterium quantifizierender Trainings-Qualitätswert als Trainingsdaten eingelesen. Derartige Trainingsdaten können einer Vielzahl von existierenden Datenbanken mit Konstruktionsunterlagen für eine große Menge von technischen Produkten entnommen werden. Erfindungsgemäß wird ein bayessches neuronales Netz anhand der Trainingsdaten darauf trainiert, anhand eines Strukturdatensatzes einen zugehörigen Qualitätswert zusammen mit einer zugehörigen Unsicherheitsangabe zu ermitteln. Weiterhin wird eine Vielzahl von synthetischen Strukturdatensätzen generiert und in das trainierte bayessche neuronale Netz eingespeist, das für die synthetischen Strukturdatensätze jeweils einen Qualitätswert mit zugehöriger Unsicherheitsangabe generiert. Die generierten Unsicherheitsangaben werden mit einer vorgegebenen Zuverlässigkeitsangabe verglichen, und abhängig davon wird einer der synthetischen Strukturdatensätze selektiert. Eine derartige Zuverlässigkeitsangabe kann hierbei insbesondere eine maximal zulässige Unsicherheit oder Ungenauigkeit eines Qualitätswerts, eine minimale Wahrscheinlichkeit einer Erfüllung eines Konstruktionskriteriums und/oder ein Intervall, einen Grenzwert oder ein Quantil für zulässige Qualitätswerte angeben. Der selektierte Strukturdatensatz wird dann zur Herstellung des technischen Produkts ausgegeben.

Zum Ausführen des erfindungsgemäßen Konstruktionsverfahrens sind ein Konstruktionssystem, ein Computerprogrammprodukt sowie ein computerlesbares, vorzugsweise nichtflüchtiges Speichermedium vorgesehen.

Das erfindungsgemäße Konstruktionsverfahren sowie das erfindungsgemäße Konstruktionssystem können beispielsweise mittels eines oder mehrerer Computer, Prozessoren, anwendungsspezifischer integrierter Schaltungen (ASIC), digitaler Signalprozessoren (DSP) und/oder sogenannter "Field Programmable Gate Arrays" (FPGA) ausgeführt bzw. implementiert werden.

Ein Vorteil der Erfindung ist insbesondere darin zu sehen, dass aufgrund einer expliziten Berücksichtigung von Unsicherheiten in der Regel robustere und/oder zuverlässigere Konstruktionsvarianten generiert werden können. Insbesondere können so auch Streuungen von Materialeigenschaften oder von Produktionsprozessen berücksichtigt werden. Die Erfindung ist zudem in vielen Fällen leicht an unterschiedliche technische Gebiete adaptierbar, sofern für ein jeweiliges technisches Gebiet eine hinreichende Menge von Trainingsdaten verfügbar ist.

Vorteilhafte Ausführungsformen und Weiterbildungen der Erfindung sind in den abhängigen Ansprüchen angegeben.

Gemäß einer vorteilhaften Ausführungsform der Erfindung können die synthetischen Strukturdatensätze durch einen trainierbaren generativen Prozess, vorzugsweise zufallsinduziert generiert werden. Zur Implementierung eines solchen generativen Prozesses sind eine Vielzahl von effizienten Verfahren verfügbar.

Insbesondere kann der generative Prozess mittels eines variationellen Autoencoders und/oder mittels generativer gegnerischer Netze ausgeführt werden. Ein variationeller Autoencoder erlaubt in vielen Fällen eine erhebliche Dimensionsreduktion eines für die Konstruktion maßgeblichen Parameterraums und damit eine erhebliche Reduktion eines erforderlichen Rechenaufwands. Generative gegnerische Netze, die häufig auch abkürzend als GAN (Generative Adversarial Networks) bezeichnet werden, erlauben eine effiziente Angleichung der generierten Strukturdatensätze an einen durch die Trainingsdaten aufgespannten Designraum.

Nach einer vorteilhaften Ausführungsform der Erfindung kann der generative Prozess anhand der Trainings-Strukturdatensätze darauf trainiert werden, anhand von eingespeisten Zufallsdaten Trainings-Strukturdatensätze zu reproduzieren. In den trainierten generativen Prozess kann dann eine Vielzahl von Zufallsdaten eingespeist werden, anhand derer durch den trainierten generativen Prozess die synthetischen Strukturdatensätze generiert werden. Durch das Training kann der generative Prozess gewissermaßen lernen, aus Zufallsdaten realistische synthetische Strukturdatensätze zu generieren. Es ist in vielen Fällen zu beobachten, dass sich ein Raum realistischer Konstruktionsvarianten durch derartig generierte synthetische Strukturdatensätze verhältnismäßig gut ausschöpfen lässt.

Weiterhin können in den trainierten generativen Prozess weitere Strukturdatensätze eingespeist werden. Die synthetischen Strukturdatensätze können dann durch den trainierten generativen Prozess abhängig von den eingespeisten weiteren Strukturdatensätzen generiert werden. Als weitere Strukturdatensätze können insbesondere Trainings-Strukturdatensätze und/oder bereits generierte Strukturdatensätze in den trainierten generativen Prozess eingespeist werden. Auf diese Weise kann eine zufallsinduzierte Generierung der synthetischen Strukturdatensätze durch vorhandene Strukturen beeinflusst werden.

Nach einer besonders vorteilhaften Ausführungsform der Erfindung kann eine Vielzahl von Datenwerten generiert und in den trainierten generativen Prozess eingespeist werden, wobei für einen jeweils eingespeisten Datenwert durch den trainierten generativen Prozess ein synthetischer Strukturdatensatz generiert wird und anhand letzterem durch das trainierte bayessche neuronale Netz ein zugehöriger Qualitätswert mit zugehöriger Unsicherheitsangabe generiert wird. Weiterhin kann im Rahmen eines Optimierungsverfahrens ein optimierter Datenwert derart bestimmt werden, dass eine durch die jeweilige Unsicherheitsangabe quantifizierte Unsicherheit verringert und/oder ein durch den jeweiligen Qualitätswert quantifiziertes Konstruktionskriterium optimiert wird. Der für den optimierten Datenwert generierte synthetische Strukturdatensatz kann dann als selektierter Strukturdatensatz ausgegeben werden. Unter einer Optimierung sei hier und im Folgenden auch eine Annäherung an ein Optimum verstanden. Zur Durchführung der Optimierung sind eine Vielzahl von Standard-Optimierungsverfahren verfügbar, insbesondere Gradientenverfahren, Genetische Algorithmen und/oder Partikelschwarmverfahren. Durch die Optimierung können im Hinblick auf das Konstruktionskriterium besonders zuverlässige und/oder vorteilhafte Konstruktionsvarianten erzeugt werden.

Vorteilhafterweise kann eine jeweilige Unsicherheitsangabe durch eine Varianz, eine Standardabweichung, eine Wahrscheinlichkeitsverteilung, einen Verteilungstyp und/oder eine Verlaufsangabe spezifiziert werden.

Weiterhin kann die für den selektierten Strukturdatensatz generierte Unsicherheitsangabe in Zuordnung zum selektierten Strukturdatensatz ausgegeben werden. Dies erlaubt eine Abschätzung darüber, wie zuverlässig das Konstruktionskriterium erfüllt wird. Insbesondere können Best-Case- und Worst-Case-Szenarien evaluiert werden.

Nach einer weiteren vorteilhaften Ausführungsform der Erfindung können mehrere Konstruktionskriterien vorgegeben werden. Das bayessche neuronale Netz kann entsprechend darauf trainiert werden, kriteriumsspezifische Unsicherheitsangaben für kriteriumsspezifische Qualitätswerte zu ermitteln. Weiterhin können für die synthetischen Strukturdatensätze jeweils mehrere kriteriumsspezifische Unsicherheitsangaben durch das trainierte bayessche neuronale Netz generiert werden. Abhängig von den generierten kriteriumsspezifischen Unsicherheitsangaben kann dann einer der synthetischen Strukturdatensätze selektiert werden. Darüber hinaus können verschiedene Konstruktionskriterien, kriteriumsspezifische Qualitätswerte und/oder kriteriumsspezifische Unsicherheitsangaben durch vorgegebene Gewichtsfaktoren gewichtet werden und eine resultierende gewichtete Summe zum Vergleich mit der Zuverlässigkeitsangabe herangezogen werden. Gegebenfalls können auch kriteriumsspezifische Zuverlässigkeitsangaben vorgesehen sein, die dann kriteriumsspezifisch mit den kriteriumsspezifischen Unsicherheitsangaben verglichen werden können.

Ein Ausführungsbeispiel der Erfindung wird nachfolgend anhand der Zeichnung näher erläutert. Dabei zeigen jeweils in schematischer Darstellung:
- Figur 1: ein Konstruktionssystem und Produktionssystem zum Herstellen eines technischen Produkts,
- Figur 2: ein bayessches neuronales Netz,
- Figur 3: einen variationellen Autoencoder in einer Trainingsphase und
- Figur 4: ein erfindungsgemäßes Konstruktionssystem in einer Anwendungsphase.

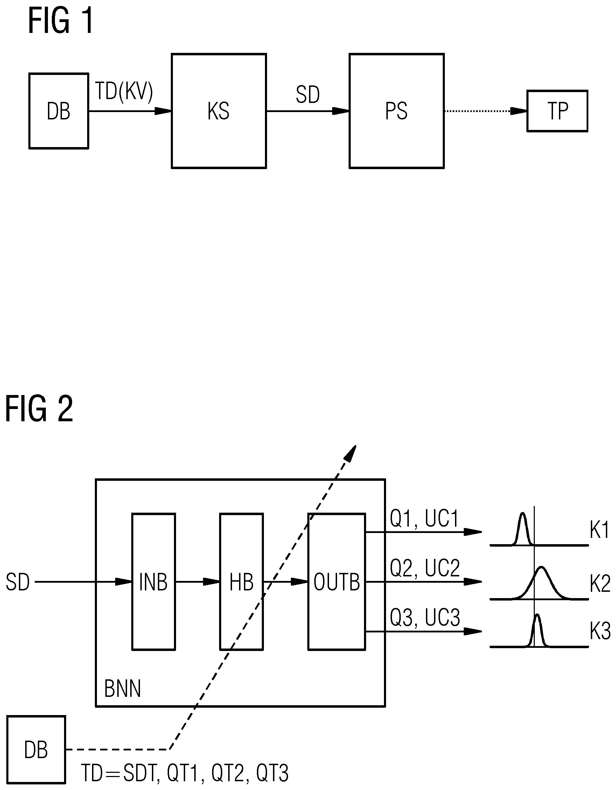

Figur 1 zeigt ein Konstruktionssystem KS und ein Produktionssystem PS zum Herstellen eines technischen Produkts TP in schematischer Darstellung. Das Produktionssystem PS ist eine Fertigungsanlage, ein Roboter oder eine Werkzeugmaschine zur Produktherstellung oder Produktbearbeitung anhand von Konstruktionsdaten oder Bearbeitungsdaten sein. Die Konstruktionsdaten oder Bearbeitungsdaten können insbesondere in Form von Strukturdatensätzen SD vorliegen, die das herzustellende Produkt TP oder einen oder mehrere von dessen Komponenten bzw. deren physikalische Struktur spezifizieren. Die Strukturdatensätze SD können dabei z.B. eine geometrische Form des technischen Produkts TP als Gittermodell oder als CAD-Modell angeben. Gegebenenfalls können die Strukturdatensätze SD auch Angaben über einen Produktions- oder Bearbeitungsprozess des technischen Produkts TP umfassen. Das herzustellende technische Produkt TP kann beispielsweise eine Turbinenschaufel, eine Windturbine, eine Gasturbine, ein Roboter, ein Kraftfahrzeug oder eine Komponente einer solchen technischen Struktur sein.

Die das technische Produkt TP spezifizierenden Strukturdatensätze SD werden durch das Konstruktionssystem KS erzeugt. Das Konstruktionssystem KS dient zum rechnergestützten Konstruieren des technischen Produkts TP und kann beispielsweise ein rechnergestütztes CAD-System umfassen oder ein Teil davon sein.

Erfindungsgemäß soll das Konstruktionssystem KS dazu befähigt werden, realistische und optimierte Strukturdatensätze SD weitgehend automatisch zu erzeugen. Zu diesem Zweck wird das Konstruktionssystem KS durch Verfahren des maschinellen Lernens in einer Trainingsphase darauf trainiert, ausgehend von einer Vielzahl von bekannten und verfügbaren Konstruktionsvarianten KV des herzustellenden technischen Produkts TP neue, durch Strukturdatensätze SD spezifizierte Konstruktionsvarianten zu generieren. Vorzugsweise sollten diese neuen Konstruktionsvarianten vorgegebene Konstruktionskriterien besser erfüllen als die bekannten Konstruktionsvarianten KV. Die Konstruktionskriterien können hierbei insbesondere eine Schwingungsneigung, einen Wirkungsgrad, eine Steifigkeit, eine Temperaturbelastung, eine Wärmeleitung, eine aerodynamische Effizienz, eine Performanz, einen Ressourcenverbrauch, einen Materialverbrauch, Emissionen, eine Materialermüdung, eine Befestigung, einen Verschleiß oder andere physikalische, chemische oder elektrische Eigenschaften des herzustellenden Produkts TP oder einer Komponente davon betreffen.

Zum Training des Konstruktionssystems KS werden eine Vielzahl von bekannten Konstruktionsvarianten KV als Trainingsdaten TD durch das Konstruktionssystem KS aus einer Datenbank DB eingelesen. Derartige Datenbanken mit Konstruktionsdaten für eine große Menge von Konstruktionsvarianten sind für eine Vielzahl von Produkten verfügbar.

Im vorliegenden Ausführungsbeispiel umfassen die Trainingsdaten TD für eine jeweilige Konstruktionsvariante KV einen oder mehrere Strukturdatensätze, die die jeweilige Konstruktionsvariante bzw. deren physikalische Struktur spezifizieren. Darüber hinaus enthalten die Trainingsdaten TD für eine jeweilige Konstruktionsvariante KV auch einen oder mehrere Qualitätswerte, die jeweils ein Konstruktionskriterium bzw. eine Erfüllung eines Konstruktionskriteriums für die jeweilige Konstruktionsvariante quantifizieren. So kann z. B. ein erster Qualitätswert eine aerodynamische Effizienz einer Konstruktionsvariante einer Turbinenschaufel angeben, ein zweiter Qualitätswert eine Kühleffizienz und ein dritter Qualitätswert eine mechanische Belastbarkeit. Insbesondere kann ein jeweiliger Qualitätswert angeben, ob und inwieweit eine ein Konstruktionskriterium betreffende Anforderung an das technische Produkt TP erfüllt wird. Die Qualitätswerte können insbesondere aus vorhandenen Messwerten, Erfahrungswerten oder Expertenbewertungen der bekannten Konstruktionsvarianten KV abgeleitet werden.

Durch das Training - das unten näher erläutert wird -, wird das Konstruktionssystem KS dazu befähigt, hinsichtlich der Konstruktionskriterien optimierte Strukturdatensätze SD zur Herstellung des technischen Produkts TP weitgehend automatisch zu generieren. In einer Anwendungsphase werden dann die durch das trainierte Konstruktionssystem KS generierten Strukturdatensätze SD an das Produktionssystem PS ausgegeben, das anhand der Strukturdatensätze SD das technische Produkt TP herstellt oder bearbeitet.

Erfindungsgemäß weist das Konstruktionssystem KS ein bayessches neuronales Netz BNN, sowie einen variationellen Autoencoder VAE auf, die beide im Rahmen des Trainings des Konstruktionssystems KS durch Verfahren des maschinellen Lernens zu trainieren sind.

Figur 2 zeigt das bayessche neuronale Netz BNN in schematischer Darstellung. Insofern in Figur 2 und den anderen Figuren die gleichen oder korrespondierende Bezugszeichen verwendet werden, bezeichnen diese Bezugszeichen die gleichen oder korrespondierende Entitäten, die wie an betreffender Stelle beschrieben, implementiert oder ausgestaltet sein können.

Das bayessche neuronale Netz BNN bildet einen sogenannten statistischen Schätzer. Ein statistischer Schätzer dient zur Ermittlung von statistischen Schätzwerten für Objekte einer Grundgesamtheit anhand von empirischen Daten einer Stichprobe der Grundgesamtheit. Ein bayessches neuronales Netz, hier BNN, kann mittels Standardverfahren des maschinellen Lernens anhand einer Stichprobe darauf trainiert werden, zu einem neuen Objekt der Grundgesamtheit einen oder mehrere Schätzwerte sowie deren Unsicherheiten zu schätzen.

Das bayessche neuronale Netz BNN umfasst im vorliegenden Ausführungsbeispiel eine Eingabeschicht INB zum Einspeisen von Eingabedaten, eine verdeckte Schicht HB sowie eine Ausgabeschicht OUTB zum Ausgeben von Ausgabedaten. Neben der verdeckten Schicht HB kann das bayessche neuronale Netz BNN noch eine oder mehrere weitere verdeckte Schichten aufweisen.

Im vorliegenden Ausführungsbeispiel wird das bayessche neuronale Netz BNN mittels der aus der Datenbank DB zugeführten Trainingsdaten TD in einer Trainingsphase darauf trainiert, neue Strukturdatensätze SD jeweils hinsichtlich mehrerer vorgegebener Konstruktionskriterien K1, K2 und K3 zu bewerten. Die Bewertung erfolgt dadurch, dass für einen jeweiligen neuen Strukturdatensatz SD zu jedem Konstruktionskriterium K1, K2 bzw. K3 jeweils ein unsicherheitsbehafteter Qualitätswert Q1, Q2 bzw. Q3 sowie dessen jeweilige Unsicherheit UC1, UC2 bzw. UC3 ausgegeben wird. Bei der Konstruktion einer Turbinenschaufel können die Konstruktionskriterien K1, K2 und K3 beispielsweise eine aerodynamische Effizienz, eine Kühleffizienz und eine mechanische Belastbarkeit der Turbinenschaufel betreffen und die Qualitätswerte Q1, Q2 und Q3 die entsprechenden Konstruktionskriterien K1, K2 und K3 quantifizieren.

Die Trainingsdaten TD enthalten für eine jeweilige Konstruktionsvariante neben einem diese Konstruktionsvariante spezifizierenden Trainings-Strukturdatensatz SDT auch für jedes zu bewertende Konstruktionskriterium K1, K2 bzw. K3 einen kriteriumspezifischen Trainings-Qualitätswert QT1, QT2 bzw. QT3, der das betreffende Konstruktionskriterium K1, K2 bzw. K3 für diese Konstruktionsvariante quantifiziert. Das Training des bayesschen neuronalen Netzes BNN anhand der Trainingsdaten TD wird in Figur 2 durch einen strichlierten Pfeil veranschaulicht.

In der Terminologie eines statistischen Schätzers können die möglichen Konstruktionsvarianten des technischen Produkts TP als Grundgesamtheit, die Trainingsdaten TD mit der Vielzahl bekannter Konstruktionsvarianten als Stichprobe, die durch den neuen Strukturdatensatz spezifizierte Konstruktionsvariante als neues Objekt sowie die unsicherheitsbehafteten Qualitätswerte als unsicherheitsbehaftete Schätzwerte aufgefasst werden.

Effiziente Trainingsverfahren für derartige bayessche neuronale Netze können beispielsweise dem Lehrbuch "Pattern Recognition and Maschine Learning" von Christopher M. Bishop, Springer 2011, entnommen werden.

Nach dem Training kann das trainierte bayessche neuronale Netz BNN in einer Anwendungsphase als statistischer Schätzer verwendet werden. Hierbei wird ein jeweils zu bewertender Strukturdatensatz SD in die Eingabeschicht INB des trainierten bayesschen neuronalen Netzes BNN eingespeist, das daraus für jedes Konstruktionskriterium K1, K2 bzw. K3 einen das jeweilige Konstruktionskriterium quantifizierenden Qualitätswert Q1, Q2 bzw. Q3 sowie eine dessen jeweilige Unsicherheit quantifizierende Unsicherheitsangabe UC1, UC2 bzw. UC3 ableitet. Die Qualitätswerte Q1, Q2 und Q3 sowie die Unsicherheitsangaben UC1, UC2 und UC3 werden von der Ausgabeschicht OUTB ausgegeben.

Die Unsicherheitsangaben UC1, UC2 und UC3 können insbesondere durch eine Streubreite, durch ein Fehlerintervall, durch ein Genauigkeitsintervall, durch eine Varianz, durch eine Standardabweichung, durch eine Wahrscheinlichkeitsverteilung, durch einen Verteilungstyp und/oder durch ein Konfidenzmaß dargestellt werden. Bei einer Wahrscheinlichkeitsverteilung kann verschiedenen möglichen Qualitätswerten jeweils ein konkreter Wahrscheinlichkeitswert zugeordnet sein. Alternativ oder zusätzlich können die ermittelten Qualitätswerte Q1, Q2 und Q3 jeweils durch einen Mittelwert oder einen Median einer Wahrscheinlichkeitsverteilung spezifiziert oder repräsentiert werden. In diesem Fall können ein Qualitätswert Q1, Q2 bzw. Q3 und die zugehörigen Unsicherheitsangaben UC1, UC2 bzw. UC3 als Wertepaar, bestehend aus Mittelwert und Varianz einer Wahrscheinlichkeitsverteilung dargestellt werden.

Die durch die eingespeisten Strukturdatensätze SD spezifizierten Konstruktionsvarianten werden durch das trainierte bayessche neuronale Netz BNN gewissermaßen im Lichte der Trainingsdaten TD hinsichtlich erwarteter Qualität und deren Unsicherheit bzw. hinsichtlich der Erfüllung der Konstruktionskriterien K1, K2 und K3 evaluiert.

Im vorliegenden Ausführungsbeispiel werden die zu evaluierenden Strukturdatensätze durch einen sogenannten generativen Prozess synthetisch generiert. Der generative Prozess wird hierbei durch einen variationellen Autoencoder VAE implementiert.

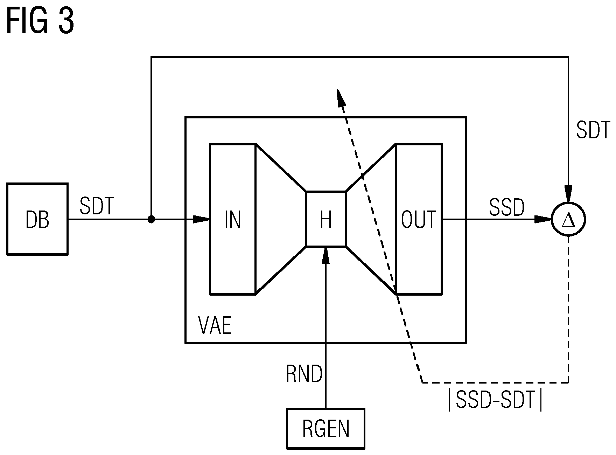

Figur 3 veranschaulicht einen solchen variationellen Autoencoder VAE in einer Trainingsphase. Der variationelle Autoencoder VAE umfasst eine Eingabeschicht IN, eine verdeckte Schicht H sowie eine Ausgabeschicht OUT. Neben der verdeckten Schicht H kann der variationelle Autoencoder VAE weitere verdeckte Schichten aufweisen. Kennzeichnend für einen Autoencoder ist, dass die verdeckte Schicht H signifikant kleiner ist, d. h. weniger Neuronen aufweist als die Eingabeschicht IN oder die Ausgabeschicht OUT.

Der variationelle Autoencoder VAE soll anhand von aus der Datenbank DB eingelesenen Trainings-Strukturdatensätzen SDT darauf trainiert werden, anhand von eingespeisten Zufallsdaten RND die Trainings-Strukturdatensätze SDT möglichst weitgehend zu reproduzieren. Zu diesem Zweck wird eine große Menge der Trainings-Strukturdatensätze SDT als Eingabedaten in die Eingabeschicht IN eingespeist und durch die Schichten IN, H und OUT verarbeitet. Die verarbeiteten Daten werden schließlich von der Ausgabeschicht OUT als Ausgabedaten ausgegeben, die im weiteren Verfahren als synthetische Strukturdatensätze SSD dienen sollen.

Das Training des variationellen Autoencoders VAE umfasst insbesondere zwei Aspekte. Gemäß einem ersten Aspekt wird der variationelle Autoencoder VAE so trainiert, dass seine Ausgabedaten, hier die synthetischen Strukturdatensätze SSD, die Eingabedaten, hier die Trainings-Strukturdatensätze SDT möglichst gut reproduzieren. Insofern die Eingabedaten gewissermaßen durch die kleinere verdeckte Schicht H hindurch müssen, und aus der dort vorliegenden, geringeren Datenmenge gemäß Trainingsziel wieder weitgehend rekonstruierbar sein sollen, erhält man in der verdeckten Schicht H eine datenreduzierte Repräsentation der Eingabedaten. Der variationelle Autoencoder VAE lernt somit eine effiziente Kodierung oder Komprimierung der Eingabedaten.

In der verdeckten Schicht H wird hierdurch ein sogenannter latenter Parameterraum oder eine latente Repräsentation der Trainings-Strukturdatensätze SDT und damit gewissermaßen ein latenter Designraum realisiert. Die in der verdeckten Schicht H vorliegenden Daten korrespondieren zu einer abstrakten Beschreibung der in den Trainings-Strukturdatensätzen SDT enthaltenen Designstrukturen und sind in vielen Fällen auch insbesondere geometrisch interpretierbar.

Die Komprimierung der Eingabedaten führt im weiteren Verlauf des Verfahrens zur Dimensionsreduktion des abzudeckenden Designraums und damit zu einer erheblichen Verringerung eines erforderlichen Rechenaufwands.

Zum Erreichen des obigen Trainingsziels wird ein Optimierungsverfahren ausgeführt, das Verarbeitungsparameter des variationellen Autoencoders VAE derart einstellt, dass ein Rekonstruktionsfehler minimiert wird. Als Rekonstruktionsfehler kann hierbei insbesondere ein Abstand zwischen synthetischen Strukturdatensätzen SSD und den Trainings-Strukturdatensätzen SDT ermittelt werden.

Gemäß einem zweiten Aspekt des Trainings des variationellen Autoencoders VAE werden zusätzlich durch einen Zufallsdatengenerator RGEN Zufallsdaten RND generiert und in die verdeckte Schicht H, d. h. in den latenten Parameterraum eingespeist, wodurch der variationelle Autoencoder VAE zur Erzeugung von synthetischen Strukturdatensätzen SSD angeregt wird. Die Zufallsdaten RND können hierbei Zufallszahlen, Pseudozufallszahlen, ein Rauschsignal und/oder andere zufallsinduzierte Daten sein.

Insofern der variationelle Autoencoder VAE wie oben beschrieben darauf trainiert wird, einen Abstand der aus den Zufallsdaten RND generierten synthetischen Strukturdatensätze SSD zu den Trainings-Strukturdatensätzen SDT zu minimieren, wird der variationelle Autoencoder VAE dazu befähigt, auf zufallsbasierte Anregung hin realistische, d. h. zu den Trainings-Strukturdatensätzen SDT möglichst ähnliche Konstruktionsvarianten zu generieren. Wenn die Trainings-Strukturdatensätze SDT und die synthetischen Datensätze SSD jeweils durch Datenvektoren repräsentiert werden, kann der zu minimierende Abstand beispielsweise als Mittelwert, Minimum oder anderes Maß eines jeweiligen euklidischen Abstands zwischen einem oder mehreren synthetischen Strukturdatensätzen SSD und mehreren oder allen Trainings-Strukturdatensätzen SDT ermittelt werden.

Zum Trainieren des variationellen Autoencoders VAE bzw. zum Optimieren seiner Verarbeitungsparameter werden die berechneten Abstände - wie in Figur 3 durch einen strichlierten Pfeil angedeutet - zum variationellen Autoencoder VAE zurückgeführt. Zur konkreten Durchführung des Trainings kann auf eine Vielzahl von effizienten Standardverfahren zurückgegriffen werden.

Nach erfolgreichem Training kann der variationelle Autoencoder VAE allein durch Einspeisen von Zufallsdaten RND in die verdeckte Schicht H dazu angeregt werden, weitgehend realistische synthetische Strukturdatensätze SSD zu generieren.

Die Nutzung eines durch Zufallsdaten anregbaren variationellen Autoencoders VAE ist insofern vorteilhaft, als auch neue, in den Trainings-Strukturdatensätzen SDT nicht explizit vorhandene Strukturen als zufallsinduzierte Designvorschläge erzeugt werden können, die aufgrund des Trainings eine Ähnlichkeit zu den Trainingsstrukturen aufweisen. Auf diese Weise kann der Raum realistischer und brauchbarer Designstrukturen in der Regel gut abgedeckt werden.

Der trainierte variationelle Autoencoder VAE implementiert einen zufallsinduzierten generativen Prozess für die synthetischen Strukturdatensätze SSD. Alternativ oder zusätzlich kann ein solcher generativer Prozess auch durch generative gegnerische Netze implementiert werden.

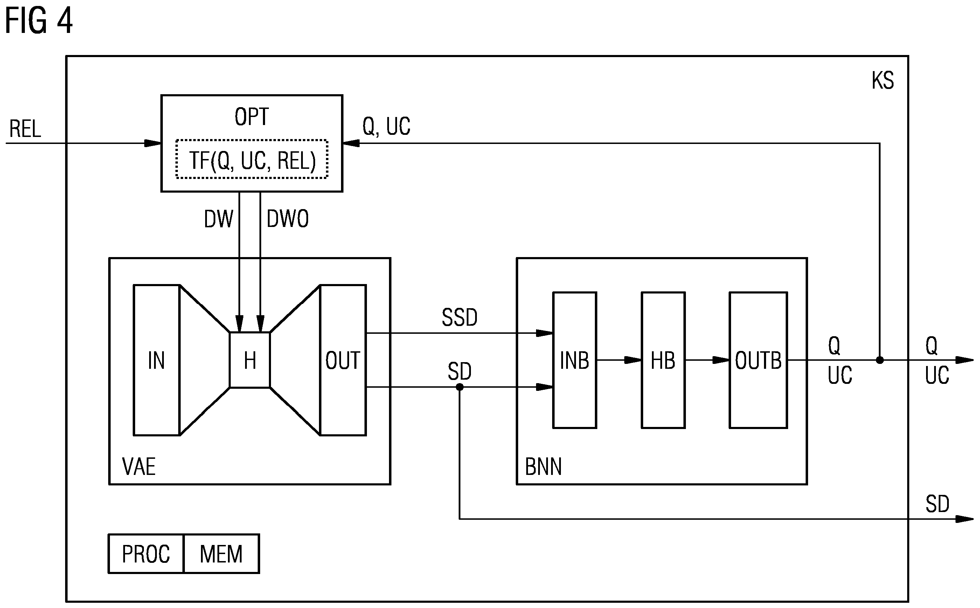

Figur 4 veranschaulicht ein erfindungsgemäßes Konstruktionssystem KS mit einem trainierten bayesschen neuronalen Netz BNN und einem trainierten variationellen Autoencoder VAE in einer Anwendungsphase. Das jeweilige Training des bayesschen neuronalen Netzes BNN und des variationellen Autoencoders VAE wurde wie vorstehend beschrieben durchgeführt.

Aus Übersichtlichkeitsgründen sind in Figur 4 Qualitätswerte Q und Unsicherheitsangaben UC nur für ein einziges Konstruktionskriterium explizit dargestellt.

Das Konstruktionssystem KS verfügt über einen oder mehrere Prozessoren PROC zum Durchführen der erforderlichen Verfahrensschritte sowie über einen oder mehrere Speicher MEM zum Speichern von zu verarbeitenden Daten.

Das Konstruktionssystem KS verfügt weiterhin über ein Optimierungsmodul OPT zum Optimieren von zu generierenden Strukturdatensätzen. Diese Strukturdatensätze werden im vorliegenden Ausführungsbeispiel hinsichtlich der resultierenden Qualitätswerte Q, den zugehörigen Unsicherheitsangaben UC sowie einer Zuverlässigkeitsangabe REL optimiert. Zu diesem Zweck ist eine zu optimierende Zielfunktion TF im Optimierungsmodul OPT implementiert. Die Zielfunktion TF berechnet abhängig vom Qualitätswert Q und der zugehörigen Unsicherheitsangabe UC einer Konstruktionsvariante sowie abhängig von der Zuverlässigkeitsangabe REL einen Gütewert, der eine Güte, eine Eignung oder eine andere Qualität dieser Konstruktionsvariante quantifiziert. Eine solche Zielfunktion wird häufig auch als Kostenfunktion oder Belohnungsfunktion bezeichnet.

Die Zuverlässigkeitsangabe REL quantifiziert eine für das technische Produkt TP geforderte Zuverlässigkeit, mit der ein jeweiliges Konstruktionskriterium zu erfüllen ist. Die Zuverlässigkeitsangabe REL kann insbesondere eine minimale Wahrscheinlichkeit, mit der ein jeweiliges Konstruktionskriterium zu erfüllen ist, eine maximal akzeptable Unsicherheit oder Ungenauigkeit eines Qualitätswerts und/oder eine maximale Ausfallwahrscheinlichkeit des technischen Produkts TP angeben.

Zur Feststellung der Zuverlässigkeit einer Konstruktionsvariante ist die Zuverlässigkeitsangabe REL insbesondere mit Unsicherheitsangaben der Qualitätswerte dieser Konstruktionsvariante zu vergleichen. Gegebenenfalls können mehrere Zuverlässigkeitskriterien und damit mehrere kriteriumsspezifische Zuverlässigkeitsangaben vorgesehen sein. Entsprechend kann eine Zuverlässigkeit einer Konstruktionsvariante durch kriteriumsspezifische Vergleiche zwischen kriteriumsspezifischen Unsicherheitsangaben und zugehörigen kriteriumsspezifischen Zuverlässigkeitsangaben festgestellt werden.

Die Zielfunktion TF kann beispielsweise so implementiert werden, dass der zu berechnende Gütewert steigt bzw. fällt, wenn ein erwünschter Qualitätswert Q des technischen Produkts TP steigt bzw. fällt und/oder eine Unsicherheitsangabe UC dieses Qualitätswerts Q fällt bzw. steigt. Entsprechend kann der Gütewert fallen, wenn die Unsicherheitsangabe UC ein durch die Zuverlässigkeitsangabe REL quantifiziertes Zuverlässigkeitskriterium nicht erfüllt und/oder der Qualitätswert Q einen durch die Zuverlässigkeitsangabe REL quantifizierten Grenzwert überschreitet. Um einen einzelnen Gütewert zu ermitteln, können unterschiedliche Optimierungskriterien der Zielfunktion TF mittels geeigneter Gewichtungsfaktoren gewichtet werden. Eine derartige Zielfunktion TF kann dann durch das Optimierungsmodul OPT mittels eines Standard-Optimierungsverfahrens maximiert werden.

Im vorliegenden Ausführungsbeispiel wird für das herzustellende technische Produkt TP eine vorgegebene Zuverlässigkeitsangabe REL zum Optimierungsmodul OPT übermittelt. Im Rahmen der Optimierung wird dann durch das Optimierungsmodul OPT eine Vielzahl von zufallsinduzierten Datenwerten DW, z.B. mittels eines Zufallsdatengenerators generiert und in die verdeckte Schicht H des trainierten variationellen Autoencoders VAE eingespeist. Durch die Datenwerte wird der trainierte variationelle Autoencoder VAE dazu angeregt, synthetische Strukturdatensätze SSD zu generieren, die wie oben bereits ausgeführt, weitgehend realistische Konstruktionsvarianten des technischen Produkts TP spezifizieren.

Die synthetischen Strukturdatensätze SSD werden in die Eingabeschicht INB des trainierten bayesschen neuronalen Netzes BNN als Eingabedaten eingespeist. Infolgedessen werden durch das trainierte bayessche neuronale Netz BNN für einen jeweiligen synthetischen Strukturdatensatz SSD ein Qualitätswert Q sowie eine Unsicherheitsangabe UC für diesen Qualitätswert Q generiert und über die Ausgabeschicht OUTB als Ausgabedaten ausgegeben. Der Qualitätswert Q quantifiziert hierbei ein Konstruktionskriterium der durch den jeweiligen synthetischen Strukturdatensatz SSD spezifizierten Konstruktionsvariante.

Die generierten Qualitätswerte Q und Unsicherheitsangaben UC werden zum Optimierungsmodul OPT übermittelt, das daraus mittels der Zielfunktion TF einen Gütewert für den jeweiligen synthetischen Strukturdatensatz SSD berechnet. Die weitere Generierung der Datenwerte DW durch das Optimierungsmodul OPT erfolgt dann derart, dass die jeweils daraus resultierenden Gütewerte maximiert oder anderweitig optimiert werden.

Die Optimierung der Datenwerte DW erfolgt vorzugsweise iterativ im latenten Parameterraum. Wie oben bereits erwähnt, kann zur konkreten Durchführung der Optimierung eine Vielzahl effizienter Standard-Optimierungsverfahren verwendet werden, wie beispielsweise Gradientenverfahren, Partikelschwarmoptimierungen und/oder genetische Algorithmen.

Auf diese Weise wird durch das Optimierungsmodul OPT ein in vorstehender Hinsicht optimierter, d.h. zu einem hohen Gütewert führender Datenwert DWO ermittelt. Letzterer wird vom Optimierungsmodul OPT in die verdeckte Schicht H des trainierten variationellen Autoencoders VAE eingespeist, der daraus einen optimierten synthetischen Strukturdatensatz SD generiert. Der optimierte synthetische Strukturdatensatz SD wird als auszugebender Strukturdatensatz selektiert und durch das Konstruktionssystem KS zur Konstruktion und Herstellung des technischen Produkts TP ausgegeben.

Darüber hinaus wird der selektierte Strukturdatensatz SD in die Eingabeschicht INB des trainierten bayesschen neuronalen Netzes BNN eingespeist, das daraus einen Qualitätswert Q für den selektierten Strukturdatensatz SD sowie eine Unsicherheitsangabe UC für diesen Qualitätswert Q ableitet. Der Qualitätswert Q und die Unsicherheitsangabe UC für den selektierten Strukturdatensatz SD werden dann in Zuordnung zu diesem Strukturdatensatz SD durch das Konstruktionssystem KS ausgegeben.

Der ausgegebene Strukturdatensatz SD spezifiziert eine optimierte, neue Konstruktionsvariante des herzustellenden Produkts TP und kann zu dessen Herstellung oder Bearbeitung zur Produktionsanlage PS übermittelt werden.

Durch die explizite Einbeziehung bzw. Minimierung von Unsicherheiten können mittels der Erfindung in der Regel robustere Konstruktionsvarianten generiert werden als mit bekannten Verfahren. In vielen Fällen erfordern die generierten Konstruktionsvarianten weniger manuelle Anpassungen und weisen eine höhere Qualität auf als andere datengetrieben erzeugte Konstruktionsvarianten. Darüber hinaus können anhand der Unsicherheitsangaben Best-Case- oder Worst-Case-Szenarien auf einfache Weise evaluiert werden. Insbesondere können Risiken einer Nichterfüllung von Konstruktionsvorgaben leichter abgeschätzt werden. Ferner können Materialschwankungen oder Schwankungen im Produktionsprozess auf natürliche Weise im erfindungsgemäßen Verfahren berücksichtigt werden. Insofern die Erfindung im Wesentlichen nur auf bewertete Trainings-Strukturdatensätze angewiesen ist, kann ein erfindungsgemäßes Konstruktionssystem KS in der Regel auf einfache Weise auf viele technische Gebiete angewandt werden, für die ausreichend viele Trainingsdaten vorliegen.

## Patentansprüche

1. Computerimplementiertes Konstruktionsverfahren zum Generieren von ein technisches Produkt (TP) spezifizierenden Strukturdatensätzen (SD), wobei
a) für eine Vielzahl von Konstruktionsvarianten (KV) des technischen Produkts (TP) jeweils ein die jeweilige Konstruktionsvariante (KV) spezifizierender Trainings-Strukturdatensatz (SDT) sowie ein ein vorgegebenes Konstruktionskriterium (K1, K2, K3) quantifizierender Trainings-Qualitätswert (QT1, QT2, QT3) als Trainingsdaten (TD) eingelesen werden,
b) ein bayessches neuronales Netz (BNN) anhand der Trainingsdaten (TD) darauf trainiert wird, anhand eines Strukturdatensatzes (SD, SSD) einen zugehörigen Qualitätswert (Q) zusammen mit einer zugehörigen Unsicherheitsangabe (UC) zu ermitteln,
c) eine Vielzahl von synthetischen Strukturdatensätzen (SSD) generiert und in das trainierte bayessche neuronale Netz (BNN) eingespeist wird,
d) für die synthetischen Strukturdatensätze (SSD) durch das trainierte bayessche neuronale Netz (BNN) jeweils ein Qualitätswert (Q) mit zugehöriger Unsicherheitsangabe (UC) generiert wird,
e) die generierten Unsicherheitsangaben (UC) mit einer vorgegebenen Zuverlässigkeitsangabe (REL) verglichen werden und abhängig davon einer der synthetischen Strukturdatensätze (SD) selektiert wird,
f) der selektierte Strukturdatensatz (SD) zur Herstellung des technischen Produkts (TP) an ein Produktionssystem (PS) ausgegeben wird, und
g) das technische Produkt (TP) durch das Produktionssystem (PS) anhand des selektierten Strukturdatensatzes (SD) hergestellt oder bearbeitet wird,
wobei das Produktionssystem (PS) eine Fertigungsanlage, ein Roboter oder eine Werkzeugmaschine ist, und
wobei ein jeweiliger Qualitätswert (Q) angibt, inwieweit eine ein Konstruktionskriterium betreffende Anforderung an das technische Produkt (TP) erfüllt wird.

2. Verfahren nach einem der vorhergehenden Ansprüche, **dadurch gekennzeichnet,**
**dass** die synthetischen Strukturdatensätze (SSD) durch einen trainierbaren generativen Prozess (VAE) generiert werden.

3. Verfahren nach Anspruch 2, **dadurch gekennzeichnet,**
**dass** der generative Prozess mittels eines variationellen Autoencoders (VAE) und/oder mittels generativer gegnerischer Netze ausgeführt wird.

4. Verfahren nach Anspruch 2 oder 3, **dadurch gekennzeichnet, dass** der generative Prozess (VAE) anhand der Trainings-Strukturdatensätze (SDT) darauf trainiert wird, anhand von eingespeisten Zufallsdaten (RND) Trainings-Strukturdatensätze (SDT) zu reproduzieren,
dass eine Vielzahl von Zufallsdaten (RND) erzeugt und in den trainierten generativen Prozess (VAE) eingespeist wird, und dass die synthetischen Strukturdatensätze (SSD) durch den trainierten generativen Prozess (VAE) anhand der eingespeisten Vielzahl von erzeugten Zufallsdaten (RND) generiert werden.

5. Verfahren nach einem der Ansprüche 2 bis 4, **dadurch gekennzeichnet,**
**dass** in einen trainierten generativen Prozess (VAE) weitere Strukturdatensätze eingespeist werden, und
**dass** die synthetischen Strukturdatensätze (SSD) durch den trainierten generativen Prozess (VAE) abhängig von den eingespeisten weiteren Strukturdatensätzen generiert werden.

6. Verfahren nach einem der Ansprüche 2 bis 5, **dadurch gekennzeichnet,**
**dass** der generative Prozess (VAE) anhand der Trainings-Strukturdatensätze (SDT) darauf trainiert wird, anhand von eingespeisten Zufallsdaten (RND) Trainings-Strukturdatensätze (SDT) zu reproduzieren,
**dass** eine Vielzahl von Datenwerten (DW) generiert und in den trainierten generativen Prozess (VAE) eingespeist wird,
**dass** für einen jeweils eingespeisten Datenwert (DW)
- durch den trainierten generativen Prozess (VAE) ein synthetischer Strukturdatensatz (SSD) generiert wird, und
- durch das trainierte bayessche neuronale Netz (BNN) anhand des synthetischen Strukturdatensatzes (SSD) ein zugehöriger Qualitätswert (Q) mit zugehöriger Unsicherheitsangabe (UC) generiert wird,
**dass** im Rahmen eines Optimierungsverfahrens ein optimierter Datenwert (DWO) derart bestimmt wird, dass eine durch die jeweilige Unsicherheitsangabe (UC) quantifizierte Unsicherheit verringert und/oder ein durch den jeweiligen Qualitätswert (Q) quantifiziertes Konstruktionskriterium optimiert wird, und
**dass** der für den optimierten Datenwert (DWO) generierte synthetische Strukturdatensatz als selektierter Strukturdatensatz (SD) ausgegeben wird.

7. Verfahren nach einem der vorhergehenden Ansprüche, **dadurch gekennzeichnet,**
**dass** eine jeweiliges Unsicherheitsangabe (UC) durch eine Varianz, eine Standardabweichung, eine Wahrscheinlichkeitsverteilung, einen Verteilungstyp und/oder eine Verlaufsangabe spezifiziert wird.

8. Verfahren nach einem der vorhergehenden Ansprüche, **dadurch gekennzeichnet,**
**dass** die für den selektierten Strukturdatensatz (SD) generierte Unsicherheitsangabe (UC) in Zuordnung zum selektierten Strukturdatensatz (SD) ausgegeben wird.

9. Verfahren nach einem der vorhergehenden Ansprüche, **dadurch gekennzeichnet,**
**dass** mehrere Konstruktionskriterien (K1, K2, K3) vorgegeben sind,
**dass** das bayessche neuronale Netz (BNN) darauf trainiert wird, kriteriumsspezifische Unsicherheitsangaben (UC1, UC2, UC3) für kriteriumsspezifische Qualitätswerte (Q1, Q2, Q3) zu ermitteln,
**dass** für die synthetischen Strukturdatensätze (SSD) jeweils mehrere kriteriumsspezifische Unsicherheitsangaben (UC1, UC2, UC3) durch das trainierte bayessche neuronale Netz (BNN) generiert werden, und
**dass** abhängig von den generierten kriteriumsspezifischen Unsicherheitsangaben (UC1, UC2, UC3) einer der synthetischen Strukturdatensätze selektiert wird.

10. Konstruktionssystem (KS) zum Generieren von ein technisches Produkt (TP) spezifizierenden Strukturdatensätzen (SD) und Produktionssystem(PS)zum Herstellen des technischen Produkts, eingerichtet zum Ausführen eines Verfahrens nach einem der vorhergehenden Ansprüche.

11. Computerprogrammprodukt umfassend Befehle, die bei Ausführung durch ein System nach Anspruch 10 dieses veranlassen, ein Verfahren nach einem der Ansprüche 1 bis 9 auszuführen.

12. Computerlesbares Speichermedium mit einem Computerprogrammprodukt nach Anspruch 11.

## Claims

1. Computer-implemented design method for generating structure data sets (SD) specifying a technical product (TP), wherein
a) for a multiplicity of design variants (KV) of the technical product (TP), in each case a training structure data set (SDT) specifying the respective design variant (KV) and also a training quality value (QT1, QT2, QT3) quantifying a predefined design criterion (K1, K2, K3) are read in as training data (TD),
b) a Bayesian neural network (BNN) is trained, on the basis of the training data (TD), to determine an associated quality value (Q) together with an associated uncertainty indication (UC) on the basis of a structure data set (SD, SSD),
c) a multiplicity of synthetic structure data sets (SSD) are generated and fed into the trained Bayesian neural network (BNN),
d) a quality value (Q) with an associated uncertainty indication (UC) is generated for each of the synthetic structure data sets (SSD) by the trained Bayesian neural network (BNN),
e) the generated uncertainty indications (UC) are compared with a predefined reliability indication (REL) and one of the synthetic structure data sets (SD) is selected depending thereon,
f) the selected structure data set (SD) is output to a production system (PS) for the purpose of producing the technical product (TP), and
g) the technical product (TP) is produced or processed by the production system (PS) on the basis of the selected structure data set (SD),
wherein the production system (PS) is a manufacturing installation, a robot or a machine tool, and
wherein a respective quality value (Q) indicates to what extent a requirement made of the technical product (TP) and concerning a design criterion is satisfied.

2. Method according to any of the preceding claims, **characterized**
**in that** the synthetic structure data sets (SSD) are generated by a trainable generative process (VAE).

3. Method according to Claim 2, **characterized**
**in that** the generative process is carried out by means of a variational autoencoder (VAE) and/or by means of generative adversarial networks.

4. Method according to Claim 2 or 3, **characterized**
**in that** the generative process (VAE) is trained, on the basis of the training structure data sets (SDT), to reproduce training structure data sets (SDT) on the basis of random data (RND) fed in,
**in that** a multiplicity of random data (RND) are generated and fed into the trained generative process (VAE), and in that the synthetic structure data sets (SSD) are generated by the trained generative process (VAE) on the basis of the fed-in multiplicity of generated random data (RND).

5. Method according to any of Claims 2 to 4, **characterized**
**in that** further structure data sets are fed into a trained generative process (VAE), and
**in that** the synthetic structure data sets (SSD) are generated by the trained generative process (VAE) depending on the further structure data sets fed in.

6. Method according to any of Claims 2 to 5, **characterized**
**in that** the generative process (VAE) is trained, on the basis of the training structure data sets (SDT), to reproduce training structure data sets (SDT) on the basis of random data (RND) fed in,
**in that** a multiplicity of data values (DW) are generated and fed into the trained generative process (VAE), in that for a data value (DW) respectively fed in
- a synthetic structure data set (SSD) is generated by the trained generative process (VAE), and
- an associated quality value (Q) with an associated uncertainty indication (UC) is generated by the trained Bayesian neural network (BNN) on the basis of the synthetic structure data set (SSD),
**in that** in the context of an optimization method an optimized data value (DWO) is ascertained in such a way that an uncertainty quantified by the respective uncertainty indication (UC) is reduced and/or a design criterion quantified by the respective quality value (Q) is optimized, and
**in that** the synthetic structure data set generated for the optimized data value (DWO) is output as selected structure data set (SD).

7. Method according to any of the preceding claims, **characterized**
**in that** a respective uncertainty indication (UC) is specified by a variance, a standard deviation, a probability distribution, a distribution type and/or a progression indication.

8. Method according to any of the preceding claims, **characterized in that** the uncertainty indication (UC) generated for the selected structure data set (SD) is output in a manner assigned to the selected structure data set (SD).

9. Method according to any of the preceding claims, **characterized**
**in that** a plurality of design criteria (K1, K2, K3) are predefined,
**in that** the Bayesian neural network (BNN) is trained to determine criterion-specific uncertainty indications (UC1, UC2, UC3) for criterion-specific quality values (Q1, Q2, Q3),
**in that** a plurality of criterion-specific uncertainty indications (UC1, UC2, UC3) are generated for each of the synthetic structure data sets (SSD) by the trained Bayesian neural network (BNN), and
**in that** one of the synthetic structure data sets is selected depending on the generated criterion-specific uncertainty indications (UC1, UC2, UC3).

10. Design system (KS) for generating structure data sets (SD) specifying a technical product (TP) and production system (PS) for producing the technical product, configured for carrying out a method according to any of the preceding claims.

11. Computer program product comprising instructions which, upon execution by a system according to Claim 10, cause said system to carry out a method according to any of Claims 1 to 9.

12. Computer-readable storage medium comprising a computer program product according to Claim 11.

## Revendications

1. Procédé de construction mis en œuvre par ordinateur destiné à la génération de jeux de données de structure (SD) spécifiant un produit technique (TP), dans lequel
a) pour une pluralité de variantes de construction (KV) du produit technique (TP) respectivement un jeu de données de structure d'entraînement (SDT) spécifiant la variante de construction respective ainsi qu'une valeur de qualité d'entraînement (QT1, QT2, QT3) quantifiant un critère de construction prédéfini (K1, K2, K3) sont lues en tant que données d'entraînement (TD),
b) un réseau neuronal bayésien (BNN) est entraîné à l'aide des données d'entraînement (TD) afin de déterminer à l'aide d'un jeu de données de structure (SD, SSD) une valeur de qualité (Q) associée conjointement avec une indication d'insécurité (UC) associée,
c) une pluralité de jeux de données de structure synthétiques (SSD) sont générés et alimentés dans le réseau neuronal bayésien entraîné (BNN),
d) pour les jeux de données de structure synthétiques (SSD) respectivement une valeur de qualité (Q) avec une indication d'insécurité associée (UC) est générée par le biais du réseau neuronal bayésien entraîné (BNN),
e) les indications d'insécurité générées (UC) sont comparées à une indication de fiabilité prédéfinie (REL) et en fonction de celle-ci un des jeux de données de structure synthétiques (SD) est sélectionné,
f) le jeu de données de structure (SD) sélectionné est envoyé pour la fabrication du produit technique (TP) à un système de production (PS), et
g) le produit technique (TP) est fabriqué ou traité par le biais du système de production (PS) à l'aide du jeu de données de structure (SD) sélectionné,
dans lequel le système de production (PS) est une installation de fabrication, un robot ou une machine-outil, et
dans lequel une valeur de qualité (Q) respective indique dans quelle mesure une demande concernant un critère de construction pour le produit technique (TP) est remplie.

2. Procédé selon l'une quelconque des revendications précédentes, **caractérisé en ce que**
les jeux de données de structure synthétiques (SSD) sont générés par le biais d'un processus génératif (VAE) pouvant être entraîné.

3. Procédé selon la revendication 2, **caractérisé en ce que** le processus génératif est réalisé au moyen d'un auto-encodeur variationnel (VAE) et/ou au moyen de réseaux génériques génératifs.

4. Procédé selon la revendication 2 ou 3, **caractérisé en ce que**
le processus génératif (VAE) est entraîné à l'aide des jeux de données de structure d'entraînement (SDT) afin de reproduire des jeux de données de structure d'entraînement (SDT) à l'aide de données aléatoires (RND) alimentées,
**en ce qu'**une pluralité de données aléatoires (RND) sont générées et alimentées dans le processus génératif (VAE) entraîné et
**en ce que** les jeux de données de structure synthétiques (SSD) sont générés par le biais du processus génératif (VAE) entraîné à l'aide de la pluralité alimentée de données aléatoires générées (RND).

5. Procédé selon l'une quelconque des revendications 2 à 4, **caractérisé en ce que**
d'autres jeux de données de structure sont alimentés dans un processus génératif entraîné (VAE), et
**en ce que** les jeux de données de structure synthétiques (SSD) sont générés par le biais du processus génératif entraîné (VAE) en fonction des autres jeux de données de structure alimentés.

6. Procédé selon l'une quelconque des revendications 2 à 5, **caractérisé en ce que**
le processus génératif (VAE) est entraîné à l'aide des jeux de données de structure d'entraînement (SDT) afin de reproduire des jeux de données de structure d'entraînement (SDT) à l'aide de données aléatoires alimentées (RND),
**en ce qu'**une pluralité de valeurs de données (DW) sont générées et alimentées dans le processus génératif entraîné (VAE),
**en ce que** pour une valeur de données (DW) respectivement alimentée
- un jeu de données de structure synthétique (SSD) est généré par le biais du processus génératif entraîné (VAE), et
- une valeur de qualité (Q) associée est générée avec une indication d'insécurité (UC) associée à l'aide du jeu de données de structure synthétique (SSD) par le biais du réseau neuronal bayésien entraîné (BNN),
**en ce que** dans le cadre d'un procédé d'optimisation une valeur de données (DWO) optimisée est déterminée de telle sorte qu'une insécurité quantifiée par le biais de l'indication d'insécurité (UC) respective est réduite et/ou un critère de construction quantifié par le biais de la valeur de qualité (Q) respective est optimisé, et
**en ce que** le jeu de données de structure synthétique généré pour la valeur de données optimisée (DWO) est émis en tant que jeu de données de structure (SD) sélectionné.

7. Procédé selon l'une quelconque des revendications précédentes, **caractérisé en ce que**
une indication d'insécurité (UC) respective est spécifiée par le biais d'une variance, d'un écart-type, d'une distribution de probabilités, d'un type de distribution et/ou d'une indication d'avancement.

8. Procédé selon l'une quelconque des revendications précédentes, **caractérisé en ce que**
l'indication d'insécurité (UC) générée pour le jeu de données (SD) sélectionné est émis en association avec le jeu de données de structure (SD) sélectionné.

9. Procédé selon l'une quelconque des revendications précédentes, **caractérisé en ce que**
plusieurs critères de construction (K1, K2, K3) sont prédéfinis, **en ce que** le réseau neuronal bayésien (BNN) est entraîné pour déterminer des indications d'insécurité spécifiques aux critères (UC1, UC2, UC3) pour des valeurs de qualité spécifiques aux critères (Q1, Q2, Q3),
**en ce que** respectivement plusieurs indications d'insécurité spécifiques aux critères (UC1, UC2, UC3) sont générées pour les jeux de données de structure synthétiques (SSD) par le biais du réseau neuronal bayésien entraîné (BNN), et
**en ce qu'**en fonction des indications d'insécurité spécifiques aux critères (UC1, UC2, UC3) générées un des jeux de données de structure synthétiques est sélectionné.

10. Système de construction (KS) destiné à la génération de jeux de données de structure (SD) spécifiant un produit technique (TP) et d'un système de production (PS) destiné à la fabrication du produit technique, mis en place pour la réalisation d'un procédé selon l'une quelconque des revendications précédentes.

11. Produit de programme informatique comprenant des instructions qui, lors d'une réalisation par le biais d'un système selon la revendication 10, amènent ce dernier à réaliser un procédé selon l'une quelconque des revendications 1 à 9.

12. Support de mémoire lisible de manière informatique avec un produit de programme informatique selon la revendication 11.
